# EUROPÄISCHE PATENTSCHRIFT

(11) **EP 0 760 873 B1**
(45) Veröffentlichungstag und Bekanntmachung des Hinweises auf die Patenterteilung: **02.12.1998**
(21) Anmeldenummer: 95920737.4
(22) Anmeldetag: 26.05.1995
(51) Int. Cl.: C25D 5/22, C25F 7/00

(54) **VERFAHREN UND VORRICHTUNG ZUM KONTINUIERLICHEN GLEICHMÄSSIGEN ELEKTROLYTISCHEN METALLISIEREN ODER ÄTZEN**
ELECTROLYTIC METHOD AND DEVICE FOR THE CONTINUOUS AND UNIFORM METALLIZATION OR ETCHING OF METAL SURFACES
PROCEDE ET DISPOSITIF DE METALLISATION OU D'ATTAQUE ELECTROLYTIQUE HOMOGENE ET CONTINUE

(30) Priorität: 26.05.1994 DE 4418278
(43) Veröffentlichungstag der Anmeldung: 12.03.1997
(73) Patentinhaber: ATOTECH Deutschland GmbH, 10553 Berlin (DE)
(72) Erfinder: SCHNEIDER, Reinhard, 90556 Cadolzburg (DE)
(74) Vertreter: Bressel, Burkhard, Dr.
(86) Internationale Anmeldenummer: DE9500706
(87) Internationale Veröffentlichungsnummer: WO9533086

(56) Entgegenhaltungen:
- US-A- 3 619 386

## Beschreibung

Die Erfindung betrifft ein Verfahren und eine Vorrichtung zum insbesondere kontinuierlichen gleichmäßigen elektrolytischen Metallisieren oder Ätzen von Metalloberflächen.

Verfahren zum Metallisieren oder Ätzen, insbesondere zur Bearbeitung und Herstellung von Leiterplatten, sowie dafür geeignete Vorrichtungen sind seit langem bekannt. Beispielsweise wird in DE 36 24 481 A1 eine Anordnung zum elektrolytischen Auftrag eines Metalles auf plattenförmige Gegenstände, wie Leiterplatten, beschrieben, bei der diese Gegenstände für eine gewisse Verweildauer in ein Elektrolysebad gebracht und dann wieder aus dem Bad entfernt werden, wobei die Gegenstände in waagerechter Lage einer die Anordnung bildenden Elektrolysekammer zugeführt, durch diese kontinuierlich hindurchgeleitet und nach der Elektrolysebehandlung aus der Kammer wieder herausgeführt werden und bei der Anoden, Stromzuführungen und Transportmittel vorgesehen sind. Ferner sind die Transportmittel als eine endlos umlaufende angetriebene Reihe einzelner Transportorgane ausgebildet, welche die Seitenränder der plattenförmigen Gegenstände festhalten und in der Transportrichtung bewegen und wobei zu Beginn und Ende des in der Elektrolysekammer gelegenen Transportweges Mittel vorgesehen sind, die ein Erfassen der Gegenstände durch die Transportorgane bzw. das Freigeben der Gegenstände durch die Transportorgane bewirken. Eine derartige Anlage ist mit entsprechender Zusatzausrüstung auch zum elektrolytischen Ätzen, beispielsweise Entfernen von Metallschichten (Entmetallisieren) verwendbar.

In anderen Anordnungen werden die zu behandelnden Gegenstände in vertikaler Lage in ein Behandlungsmittel eingetaucht oder durch Sprühen oder Spritzen mit diesem in Kontakt gebracht, wobei die für die elektrolytische Behandlung erforderlichen Gegenelektroden den Gegenständen gegenüberliegend angeordnet werden. Für eine elektrolytische Metallisierung werden die Gegenelektroden als Anode, für einen Ätzprozeß als Kathode polarisiert.

In den bekannten elektrolytischen Anlagen, in denen die Gegenstände horizontal angeordnet und in horizontaler Richtung durch die Anordnung hindurchbewegt werden, beträgt der Abstand zwischen den Gegenständen und den Gegenelektroden etwa 100 mm. Bei der Herstellung von Leiterplatten wirken sich derart große Abstände auf die Qualität der zu bearbeitenden Schichten nachteilig aus. Schmale Leiterzüge auf den Leiterplatten wirken in Bezug auf benachbarte breite Leiterzüge als Spitzen, auf die sich das elektrische Feld in der elektrolytischen Behandlungszelle konzentriert. Daher bildet sich an diesen Stellen eine höhere örtliche Stromdichte aus, so daß diese Stellen somit intensiver, d.h. schneller, elektrolytisch geätzt oder metallisiert werden als breite Leiterzüge.

Im Ergebnis sind Schichtdickenverhältnisse von 1 : 3 und mehr an den verschiedenen Stellen auf der Oberfläche einer Leiterplatte anzutreffen. Beim Ätzen führen die unterschiedlichen elektrischen Feldstärken zum Angriff auf die seitlichen Flanken eines Leiterzuges und damit zu Unterätzungen. Dies ist in der Feinleitertechnik, bei denen Leiterbahnbreiten von 0,1 mm und weniger erzeugt werden sollen, nicht mehr tolerierbar.

Zur Lösung dieses Problems sind verschiedene Maßnahmen, einzeln oder in Kombination, möglich. So kann beispielsweise die elektrolytische Behandlung mit einer niedrigen Stromdichte durchgeführt werden. Allerdings sinkt dadurch die Effizienz der Behandlungsanlage. Verbesserungen werden auch mit einem vergrößerten Anoden-/Kathodenabstand erreicht. Andererseits läßt sich die beschriebene Spitzenwirkung auch dadurch vermeiden, daß der Anoden-/ Kathodenabstand soweit reduziert wird, daß die schmalen Leiterzüge nicht mehr als Spitzen sondern als Flächen wirken. Dies ist insbesondere dann der Fall, wenn die Gegenelektroden (beim Ätzen die Kathoden und beim Metallisieren die Anoden) den zu behandelnden Gegenständen auf einen Abstand von 1 mm oder weniger angenähert werden. In diesem Falle wird die maximal anwendbare Stromdichte nur noch von der geforderten Qualität der zu bearbeitenden bzw. herzustellenden Metallschichten und der Dicke der spezifischen oberflächlichen Diffusionsschicht, die wiederum von der Intensität der Konvektion des Elektrolyten an der Behandlungsstelle beeinflußt wird, begrenzt. Die maximale Stromdichte liegt deutlich über der Stromdichte, die bei Leiterzügen, die als Spitzen wirken, anwendbar ist. Deshalb ist eine elektrolytische Behandlung mit extrem kleinen Anoden-/Kathodenabständen zu bevorzugen.

Derartige Vorrichtungen, die beispielsweise zur Behandlung von bandartigen Trägermaterialien oder Metallbändern eingesetzt werden, sind in DE-OS 25 11 336 und EP 0 264 510 A1 beschrieben.

Kleine Abstände zwischen den Anoden und Kathoden sind insbesondere mit walzenförmigen Elektroden, die auf der Oberfläche des Behandlungsgutes abrollen, realisierbar. Eine derartige Anordnung ist in WO 94/03655 A1 beschrieben.

Zur Vermeidung von elektrischen Kurzschlüssen ist hier ein isolierendes Distanzmittel zwischen den walzenförmigen Elektroden und dem zu behandelnden Gegenstand vorgesehen. Hierzu eignen sich beispielsweise partielle Beschichtungen der Walzen, die derart ausgeführt sind, daß die Stromdurchlässigkeit durch den zwischen den Walzen und dem Behandlungsgut liegenden Flüssigkeitsfilm weitgehend erhalten bleibt. Desweiteren ist es auch möglich, den auf die Leiterplattenoberfläche aufgebrachten Resist, der das Leiterbild positiv oder negativ darstellt, als Distanzmittel zu nutzen. Dieser ist elektrisch isolierend und seine Schichtdicke ist so groß, daß Kurzschlüsse sicher vermieden werden.

Derartige Walzen können beispielsweise als unlösliche Elektroden ausgebildet sein. Zur elektrischen Kontaktierung müssen diese wegen der Rotation über Schleifringe und Schleifbürsten mit der Badstromquelle elektrisch leitend verbunden werden. Diese Schleifringtechnik ist jedoch technisch aufwendig. Derartige Anordnungen sind in den Patentanmeldungen DE-P 44 17 550.7 und DE-P 44 17 551.5 dargestellt. Als isolierende Distanzmittel werden dort beispielsweise elektrisch nichtleitende Distanzringe auf der Walze oder die isolierende Schicht eines Photoresists auf der Leiterplattenoberfläche eingesetzt. Zur Kontaktierung werden Schleifkontaktbürsten, die an Schleifringen an den zu kontaktierenden Walzen angebracht sind, verwendet.

Aus der US-A-3,619,386 sind eine Vorrichtung und ein Verfahren bekannt, mit dem Metallfilme elektrolytisch abgeschieden werden können. Eine nicht elektrisch kontaktierte bipolare Aktivierungselektrode ist als von zwei Rollen umgelenktes Band ausgebildet, welches unter Druck kontinuierlich die Kathodenoberfläche berührt. Dabei passiert die Oberfläche des Bandes eine Anode und eine Kathode, wobei es von der Anode gelöstes und vom Band mitgerissenes Metall auf der Kathodenoberfläche abscheidet. Die Oberfläche des Bandes enthält Metall und daran gebundene elektrisch nichtleitende Partikel der Knoop-Härte HK 10 nach ASTM. Die Partikel wirken abrasiv auf die Kathodenoberfläche. Das Verfahren ist als Hochstromverfahren ausgelegt.

Auch beim elektrolytischen Ätzen mit den bekannten Verfahren und Anordnungen ist die Schleifringtechnik erforderlich, um die unlösliche walzenförmige Elektrode an die Badstromquelle anzuschließen. Wird die walzenförmige Elektrode zwischen dem Behandlungsgut und einer dem Behandlungsgut gegenüberliegenden Elektrode angeordnet, so schlägt sich sowohl beim elektrolytischen Ätzen als auch beim Metallisieren auf dieser Elektrode Metall ab, beim Metallisieren auf der dem Behandlungsgut abgewandten Seite, beim Ätzen auf der dem Behandlungsgut zugewandten Seite der Walze. Das Metall muß daher fortlaufend oder in zeitlich wiederkehrenden Behandlungszyklen von dieser Elektrode wieder entfernt werden. Zum kontinuierlichen Abtrag eignet sich eine zweite Badstromquelle, die beim Metallisieren gegenüber der Elektrode positiv und beim Ätzen gegenüber der Elektrode negativ polarisiert ist. Beispielsweise kann das Behandlungsgut, eine Leiterplatte, in horizontaler Lage und horizontaler Richtung durch eine Behandlungsanlage hindurchgefördert werden. Die walzenförmige Elektrode, die mindestens an ihrer Oberfläche elektrisch leitfähig ist, rollt auf der Behandlungsgutoberfläche ab, wobei ein isolierendes Distanzmittel vorgesehen ist, das einen elektrischen Kurzschluß zwischen der Elektrode und dem Behandlungsgut vermeidet.

Beim Ätzen wird der Pluspol der Stromquelle in für sich bekannter Weise mit dem Behandlungsgut, beispielsweise über elektrisch kontaktierende Klammern, elektrisch verbunden. Der Minuspol wird über einen Schleifkontakt und einen Schleifring an die Elektrode angeschlossen. Auf ihr wird das abgeätzte Metall abgeschieden. Eine zweite elektrolytische Zelle wird von einer weiteren Badstromquelle, der Elektrode und einer weiteren Hilfselektrode gebildet, wobei die zweite Zelle auf der dem Behandlungsgut abgewandten Seite der Elektrode angeordnet ist. Der Pluspol der zweiten Badstromquelle wird über denselben Schleifkontakt und Schleifring mit der Elektrode verbunden wie der Minuspol der ersten Badstromquelle und ihr negativer Pol mit der dem Behandlungsgut gegenüberliegenden Elektrode. Auf dieser scheidet sich das Metall ab, das von der Elektrode nach dem Abätzen vom Behandlungsgut wieder abgelöst wird.

Falls von der Elektrode beim Metallisieren abgeschiedenes Metall nicht vollständig wieder entfernt wird, kann dieses abgeätzt werden, indem die Badstromquellen in für sich bekannter Weise intermittierend umgepolt und unlösliche Metalloberflächen aufweisende Platten in der Anlage mitbehandelt werden. In diesem Fall löst sich das Metall von den Elektroden wieder ab und scheidet sich auf den in diesem Fall kathodisch geschalteten Gegenelektroden ab, wobei sich kein neues Metall auf den Elektroden ablagert.

Bei derartigen Verfahren muß die Elektrode über Schleifkontakte elektrisch kontaktiert werden. Dies ist konstruktiv aufwendig und erfordert eine intensive Wartung. Darüber hinaus wird auch eine zusätzliche Badstromquelle benötigt. Ferner ist das Behandlungsverfahren für das Entfernen des auf den Elektroden abgeschiedenen Metalls von Zeit zu Zeit zu unterbrechen.

Anstelle einer unlöslichen Gegenelektrode können grundsätzlich auch lösliche oder zumindest teilweise lösliche Gegenelektroden verwendet werden. In diesem Falle müssen jedoch geeignete Maßnahmen getroffen werden, um die Metallionenkonzentration in der Elektrolytflüssigkeit konstant zu halten. Im Falle der Metallisierung des Behandlungsgutes werden dem Elektrolyten hierzu beispielsweise Salze des abzuscheidenden Metalls zugegeben. Beim Ätzen müssen diese durch geeignete Verfahren aus dem Elektrolyten wieder entfernt werden. Eine fortlaufende Ergänzung der Metallsalze hat einen ständigen Verbrauch von Metallsalzen zur Folge, wobei sich kontinuierlich Abbauprodukte im Elektrolyten anreichern, die wiederum aufwendig aus dem Elektrolyten entfernt und entsorgt werden müssen. Die Verwendung von kostengünstigen löslichen Elektroden ist nicht möglich, weil diese infolge ihrer Auflösung nicht formstabil sind und deshalb keine gleichbleibend kleine Wirkungsdistanz zwischen Anode und Kathode zulassen.

Der vorliegenden Erfindung liegt von daher das Problem zugrunde, ein Verfahren zum kontinuierlichen gleichmäßigen elektrolytischen Metallisieren oder Ätzen (Entmetallisieren) von Metalloberflächen, insbesondere auch von Leiterplatten und Leiterfolien, sowie eine zur Durchführung eines derartigen Verfahrens geeignete Vorrichtung zu finden. Insbesondere sollen Nachteile der bekannten Verfahren und Anordnungen vermieden, deren Vorteile jedoch genutzt werden.

Das Problem wird gelöst durch die Ansprüche 1, 6 und 10. Vorteilhafte Ausführungsformen der Erfindung sind in den Unteransprüchen angegeben. Unter Metalloberflächen werden auch Oberflächen nichtmetallischer Materialien verstanden, die wenigstens teilweise mit Metall belegt sind.

Bei dem erfindungsgemäßen Verfahren werden insbesondere geringe Wirkungsabstände zwischen den Anoden und Kathoden ermöglicht, so daß sehr gleichmäßige Metallschichten auf Leiterplatten und Leiterfolien mit schmalen und breiten Leiterzügen erhalten werden können. Für ein kontinuierliches Metallisieren werden lösliche Anoden als Gegenelektroden verwendet. Eine Ergänzung der Metallionen durch Zugabe von Metallsalzen in die Elektrolytflüssigkeit ist nicht erforderlich. Beim elektrolytischen Ätzen wird das Metallisieren z.B. während der Leiterplattenherstellung nicht durch zyklische Entmetallisierungsvorgänge der Elektroden unterbrochen. Die erfindungsgemäße Anordnung ist zudem einfach konstruiert und erfordert keinen umfangreichen Wartungsaufwand, da keine komplizierte Schleifkontakttechnik für rotierende Walzenelektroden eingesetzt werden muß.

In der erfindungsgemäßen Vorrichtung werden Elektroden, die aus den metallischen Oberflächen des Behandlungsgutes und diesen gegenüberliegenden Gegenelektroden gebildet werden, in einer elektrolytischen Zelle angeordnet. Als Gegenelektroden können insbesondere Platten verwendet werden. An diese Elektroden wird die Badstromquelle angeschlossen. Zwischen dem Behandlungsgut und den Gegenelektroden befinden sich bewegliche, beispielsweise rotierende walzenförmige Elektroden, die nicht an die Badstromquelle angeschlossen sind. Der Abstand zwischen dem Behandlungsgut und den Gegenelektroden wird durch diese Zwischenelektroden weitgehend überbrückt. Zumindest an Teilen der Außenfläche bestehen die Zwischenelektroden aus elektrisch leitfähigem Material. Sie sind jedoch elektrisch isoliert gelagert und bewegen sich beispielsweise rollend in sehr geringem Abstand zu den Oberflächen des Behandlungsgutes. In einer Ausführungsform der Erfindung können die Zwischenelektroden die Oberflächen des Behandlungsgutes auch wischend berühren, indem deren Bewegungs- oder Drehgeschwindigkeit relativ zur Oberfläche des Behandlungsgutes in gegeigneter Weise eingestellt wird.

Zur Vermeidung der direkten metallischen Berührung zwischen dem Behandlungsgut und der metallischen Oberfläche der Zwischenelektroden befinden sich zwischen diesen elektrisch isolierende Distanzmittel, die flüssigkeits- und ionendurchlässig sind, beispielsweise keramische Partikel oder partielle Kunststoffbeschichtungen, textile Gewebe oder Kunstoffringe oder anderes profiliertes Material an der Außenseite der Zwischenelektrode. Deren Form und Anordnung wird so gewählt, daß die elektrischen Feldlinien im wesentlichen ungehindert durch den zwischen den Zwischenelektroden und dem Behandlungsgut angeordneten dünnen Flüssigkeitsfilm hindurchtreten können. Die elektrische Abblendwirkung dieser Distanzmittel ist gering. Beispielsweise können Abblendeffekte der einzelnen Distanzmittel kompensiert werden, indem die Distanzmittel auf Walzen, die entlang der Transportrichtung in der Behandlungsanlage angeordnet sind, gegeneinander versetzt angeordnet werden. Die Zwischenelektrode wird vorzugsweise aus einem unlöslichen Material ausgeführt, beispielsweise aus Edelstahl oder Titan mit oder ohne Beschichtung aus Edelmetallen oder deren Oxiden.

Der Abstand der Zwischenelektroden zur Gegenelektrode ist so groß bemessen, daß auch hier eine Berührung sicher vermieden wird.

Derartige zwischen dem Behandlungsgut und den Elektroden isoliert angeordnete Zwischenelektroden werden auf der Seite, die der Anode zugewandt ist, metallisiert und auf der Seite, die der Kathode zugewandt ist, entmetallisiert, das heißt geätzt. Beim Metallisieren des Behandlungsgutes wird daher Metall auf der dem Behandlungsgut abgewandten Seite der Zwischenelektrode und beim Ätzen auf der dem Behandlungsgut zugewandten Seite abgeschieden.

Die Zwischenelektroden können durch geeignete Ausführung auch dazu dienen, Behandlungsflüssigkeit an die Oberfläche des Behandlungsgutes zu transportieren. Hierzu können die Zwischenelektroden beispielsweise aus einem durchbrochenen Innenrohr und einem dieses umgebenden Metallgewebe zur gleichmäßigen Verteilung des ausströmenden Behandlungsmittels bestehen. Geeignete Ausführungsformen für derartige walzenförmige Elektroden sind in WO 94/03655 A1 sowie in der internationalen Patentanmeldung WO 95/20692 A1 beschrieben.

Die vorliegende Erfindung wird anhand der schematischen Figuren, ohne die Erfindung darauf zu beschränken, im Prinzip und beispielhaft dargestellt und beschrieben. Es zeigen:
- Figur 1: eine erfindungsgemäße prinzipielle Vorrichtung;
- Figur 2: eine Prinzipdarstellung des erfindungsgemäßen Ätzverfahrens;
- Figur 3: eine Prinzipdarstellung des erfindungsgemäßen Metallisierungsverfahrens.

Aus Gründen der zeichnerischen Vereinfachung sind die Vorrichtungen nicht maßstabsgetreu wiedergegeben.

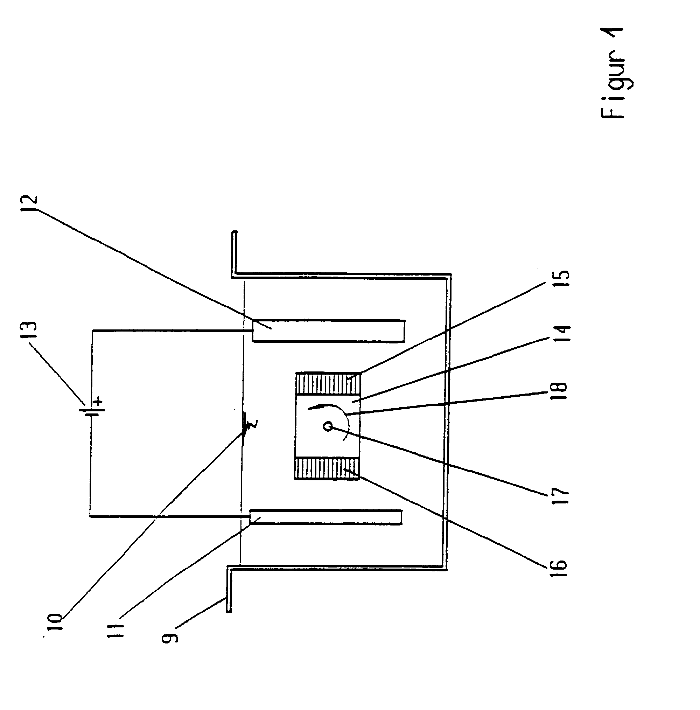

Nach Figur 1 befinden sich in einem Badbehälter 9 mit Elektrolytflüssigkeit 10 eine Kathode 11 und eine Anode 12. Eine Badstromquelle 13 ist elektrisch mit der Anode und der Kathode verbunden. Wird in die Anoden-/Kathodenstrecke bei eingeschalteter Badstromquelle ein elektrischer Leiter, hier ein mit metallischer Oberfläche versehenes Teil oder ein Metallteil 14, eingebracht, das keinen Kontakt zur Anode oder Kathode hat, so scheidet sich im Bereich 15 des Teiles Metall ab, das sich von der Anode infolge des Elektrolysevorganges abgelöst hat. Ist das Metallteil 14 selbst löslich, so wird vom Bereich 16 des Teiles Metall elektrolytisch abgetragen und auf der Kathode 11 abgeschieden. Ist das Metallteil in der Elektrolytflüssigkeit dagegen unlöslich, so entsteht an dem der Kathode zugewandten Bereich 16 Gas.

Mit der Bezugsziffer 17 ist eine Achse symbolisiert, um die das Metallteil gedreht werden kann. Nach einer 180° - Drehung des Metallteiles in Pfeilrichtung 18 steht das im Bereich 15 abgeschiedene Metall nunmehr der Kathode gegenüber. Hier wird es wieder abgeätzt und auf der Kathode endgültig abgeschieden. Gleichzeitig scheidet sich jetzt von der Anode abgeätztes Metall in dem Bereich 16 ab. Dieser Vorgang wiederholt sich bei entsprechender Relativbewegung zu den Elektroden, beispielsweise bei fortlaufender Rotation des Metallteiles.

Der Elektrolysestrom durch das nicht elektrisch kontaktierte Metallteil kommt wegen der sehr unterschiedlichen elektrischen Leitfähigkeiten der Elektrolytflüssigkeit und des Metallteiles zustande. Das Metallteil dient als elektrischer Leiter zwischen den Elektroden, der Kathode 11 und der Anode 12. Es handelt sich bei diesem Zwischenelement also um eine Zwischenelektrode. In einer bevorzugten Ausführungsform ist die Zwischenelektrode als langgestreckte Walze ausgebildet, die in sehr geringem Abstand an der Oberfläche des Behandlungsgutes abrollt. Beispielsweise kann eine derartige Walze oder ein äquivalent bewegliches Element an der Oberfläche eines in vertikaler Lage in die Behandlungsflüssigkeit eingetauchten ebenen Gegenstandes entlanggeführt werden.

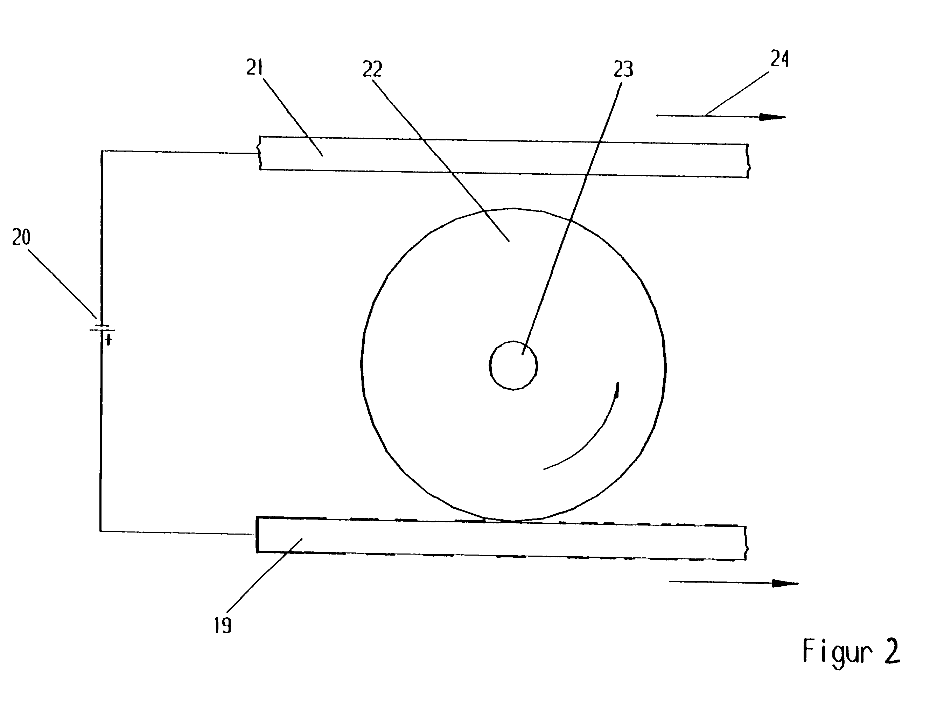

Das erfindungsgemäße Verfahren eignet sich insbesondere zur Behandlung von Leiterplatten und Leiterfolien, die in horizontaler Lage und in horizontaler Richtung durch eine Behandlungsanlage hindurchgeführt werden. Eine derartige Anordnung der Elektroden und der Badstromquelle ist in Figur 2 für einen Ätzprozeß dargestellt.

Das zu ätzende Behandlungsgut 19 ist über nicht dargestellte elektrisch kontaktierende Klammern mit dem Pluspol der Badstromquelle 20 verbunden. Der andere Pol der Badstromquelle ist an eine Kathode 21 angeschlossen. Eine vertikal zur Darstellungsebene langgestreckte Walze 22 als Zwischenelektrode ist zumindest an ihrer Oberfläche elektrisch gut leitfähig. Sie ist mit ihrem Lagerzapfen 23 höhenbeweglich gelagert, so daß unterschiedliche Leiterplattendicken selbsttätig ausgeglichen werden. Ein sehr geringer Abstand zwischen der Oberfläche des Behandlungsgutes und der walzenförmigen Zwischenelektrode wird durch isolierende und vorzugsweise sehr dünne Distanzmittel ermöglicht und konstant gehalten, die hier nicht dargestellt sind. Die Walze rotiert mit einer Umfangsgeschwindigkeit, die vorzugsweise der Transportgeschwindigkeit des Behandlungsgutes in horizontaler Richtung entspricht. Werden unterschiedliche Geschwindigkeiten gewählt, wischt die Oberfläche der Zwischenelektrode an der Oberfläche des Behandlungsgutes entlang.

Der Abstand der als Kathode polarisierten Gegenelektrode 21 von der Walze ist für die Qualität der elektrolytischen Bearbeitung des Behandlungsgutes unkritisch. Durch sporadisches Versetzen der Kathode in Pfeilrichtung 24 kann die Stelle, an der sich die größte Menge des vom Behandlungsgut abgeätzten Metalls ablagert und die sich im Wirkungsbereich der Walze befindet, seitwärts verschoben werden, so daß ein neuer Oberflächenbereich der Kathode, an dem sich noch kein oder nur wenig Metall abgeschieden hat, in den genannten Bereich bewegt wird. Dadurch wird die verfügbare Kathodenoberfläche zur Ablagerung von abgeätztem Metall vollständig nutzbar.

Vorteilhaft ist hierbei, daß in dem beschriebenen Ätzprozeß eine Metallrückgewinnung stattfindet. Zusätzliche chemische Rückgewinnungsverfahren sind daher nicht erforderlich. Beim elektrolytischen Ätzen gelangt das Metall vom Behandlungsgut zunächst auf die Walze und dann auf die Kathode. Hierzu ist erfindungsgemäß nur eine Badstromquelle erforderlich. Ferner ist auch keine elektrische Kontaktierung der Walze nötig. In einer Ätzanlage ist vorzugsweise eine Vielzahl von Walzen in Durchlaufrichtung des Behandlungsgutes hintereinander angeordnet. Desgleichen können diese zur beidseitigen und/oder synchronen Behandlung der Leiterplatten auch auf deren Unterseiten angeordnet werden.

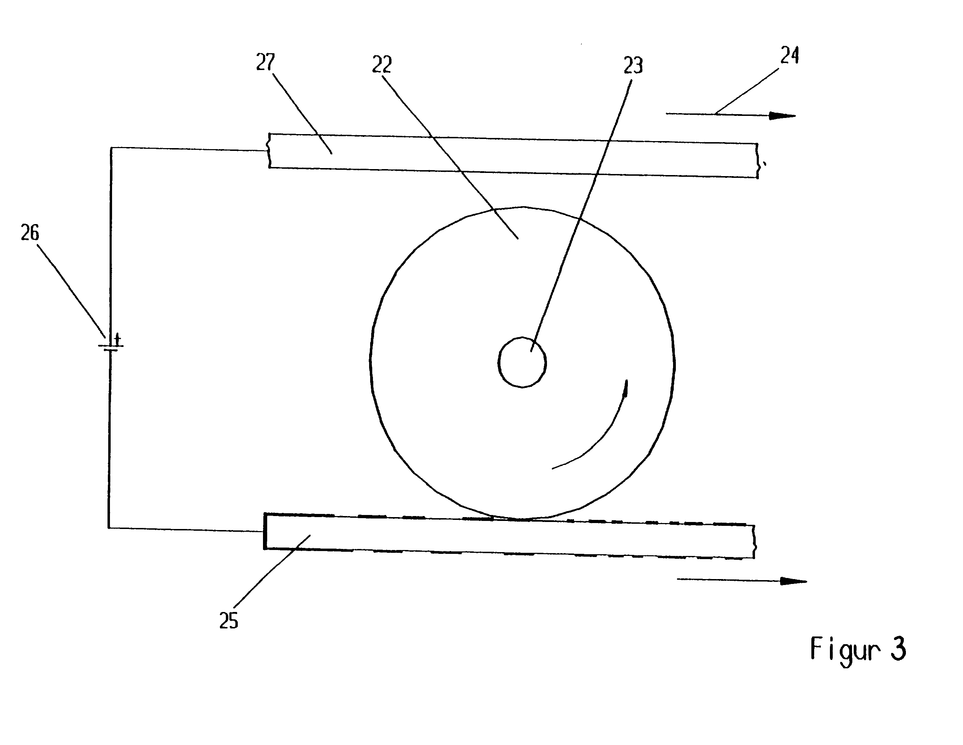

In Figur 3 ist eine Prinzipdarstellung für die Metallisierung von Leiterplatten 25 in horizontaler Lage dargestellt. Die Badstromquelle 26 ist mit dem Pluspol an die dem Behandlungsgut 25 gegenüberliegende Gegenelektrode (Anode) 27 angeschlossen, der negative Pol an das Behandlungsgut 25. Die rotierende Walze 22 ist, wie bereits anhand Figur 2 beschrieben wurde, als Zwischenelektrode ausgebildet. Die Anode 27 kann sowohl als unlösliche als auch als lösliche Elektrode ausgebildet werden. In beiden Fällen wird ein sehr kleiner konstanter Abstand zwischen dem Behandlungsgut und der Zwischenelektrode eingestellt. Unabhängig davon ist die Strecke zwischen der Anode und der Walze für die Qualität der abgeschiedenen Metallschicht auf dem Behandlungsgut unkritisch. Dies erlaubt, kostengünstige lösliche Anoden einzusetzen, deren Geometrie durch die permanente Auflösung nicht konstant gehalten werden kann und daher für einen direkten Einsatz ohne die erfindungsgemäße Zwischenelektrode und mit sehr kleinem Abstand zwischen Anode und Kathode ungeeignet wäre.

Durch sporadisches Versetzen der löslichen Anoden in Transportrichtung 24 werden auch in diesem Fall nacheinander alle Bereiche der Anoden zum Metallisieren genutzt. Der der oberen Mantellinie der Walze gegenüberliegende Bereich an der Anode wird ständig am stärksten geätzt. Durch das Versetzen in Richtung 24 werden Bereiche der Anode, von denen noch kein Metall oder nur wenig Metall abgeätzt wurden, in eine der genannten Mantellinie der Walze gegenüberliegende Stellung gebracht.

Zur beidseitigen elektrolytischen Metallisierung der Leiterplatten befinden sich auch an deren Unterseite entsprechende Vorrichtungen mit walzenförmigen Zwischenelektroden.

## Patentansprüche

1. Verfahren zum kontinuierlichen gleichmäßigen elektrolytischen Metallisieren oder Ätzen von Metalloberflächen von Leiterplatten oder Leiterfolien, bei dem
- die Metalloberflächen und diesen gegenüberliegende Elektroden mit einem Behandlungsmittel in Kontakt gebracht werden,
- zwischen den Metalloberflächen und den Elektroden eine elektrische Spannung angelegt wird und
- zwischen den Metalloberflächen und den Elektroden elektrisch nicht kontaktierte, unlösliche, zumindest an Teilen der Außenfläche aus einem elektrisch leitenden Material bestehende Zwischenelektroden angeordnet sind, die mit geringem Abstand zu den Metalloberflächen abrollen, oder
- die Zwischenelektroden die Metalloberflächen wischend berühren, wobei zwischen den Zwischenelektroden und den Metalloberflächen eine elektrisch isolierende Zwischenschicht eingebracht wird und die Bewegungsgeschwindigkeit der Zwischenelektroden relativ zur Metalloberfläche in geeigneter Weise eingestellt wird.

2. Verfahren nach Anspruch 1, gekennzeichnet durch eine um ihre Längsachse drehende Rolle als Zwischenelektrode.

3. Verfahren zum Metallisieren nach einem der vorstehenden Ansprüche, dadurch gekennzeichnet, daß zum Metallisieren benötigte Metallionen dem Behandlungsmittel durch elektrolytisches Auflösen der Elektroden oder durch Metallsalze zugeführt werden.

4. Verfahren nach einem der vorstehenden Ansprüche, dadurch gekennzeichnet, daß die Elektroden kontinuierlich oder intermittierend relativ zu den Zwischenelektroden bewegt werden.

5. Verfahren nach einem der vorstehenden Ansprüche, dadurch gekennzeichnet, daß die Leiterplatten oder Leiterfolien beim Metallisieren oder Ätzen in horizontaler Lage angeordnet und horizontaler Richtung geführt werden.

6. Vorrichtung zum kontinuierlichen gleichmäßigen elektrolytischen Metallisieren oder Ätzen von Metalloberflächen auf Leiterplatten oder Leiterfolien, umfassend
- die Metalloberflächen,
- diesen gegenüberliegende Elektroden,
- ein mit den Metalloberflächen und den Elektroden in Kontakt stehendes Behandlungsmittel,
- eine mit den Metalloberflächen und den Elektroden in elektrischem Kontakt stehende Spannungsquelle sowie
- zwischen den Metalloberflächen und den Elektroden angeordnete, elektrisch nicht kontaktierte unlösliche, zumindest an Teilen der Außenfläche aus einem elektrisch leitenden Material bestehende und außen mit einer elektrisch isolierenden Zwischenschicht versehene, drehbare, als Rolle ausgebildete Zwischenelektroden.

7. Vorrichtung nach Anspruch 6, dadurch gekennzeichnet, daß die Zwischenelektrode auf ihrer Außenfläche mit elektrisch isolierenden Distanzmitteln versehen ist.

8. Vorrichtung nach einem der Ansprüche 6 oder 7, dadurch gekennzeichnet, daß die Elektroden als Platten ausgebildet sind.

9. Vorrichtung zum Metallisieren nach einem der Ansprüche 6 bis 8, gekennzeichnet durch aus abzuscheidendem Material bestehende Elektroden.

10. Verwendung einer Vorrichtung nach einem der Ansprüche 6 bis 9 zum Metallisieren oder Ätzen von in horizontaler Lage angeordneten und horizontal geführten Leiterplatten oder Leiterfolien.

## Claims

1. Method for the continuous, uniform, electrolytic metallization or etching of metal surfaces on printed circuit boards or conductor foils, wherein
- the metal surfaces and electrodes, which are situated opposite said surfaces, are brought into contact with a treatment agent,
- an electrical voltage is applied between the metal surfaces and the electrodes, and
- electrically non-contacted, insoluble intermediate electrodes, which are formed from an electrically conductive material, at least at portions of the external surface, are disposed between the metal surfaces and the electrodes and travel at a small spacing from the metal surfaces, or
- the intermediate electrodes are in wiping contact with the metal surfaces, an electrically insulating intermediate layer being introduced between the intermediate electrodes and the metal surfaces, and the speed of movement of the intermediate electrodes relative to the metal surface is set in a suitable manner.

2. Method according to claim 1, characterised by a roller, which rotates about its longitudinal axis, as the intermediate electrode.

3. Metallizing method according to one of the preceding claims, characterised in that metal ions, which are required for the metallization, are supplied to the treatment agent by electrolytically dissolving the electrodes or by metal salts.

4. Method according to one of the preceding claims, characterised in that the electrodes are moved continuously or intermittently relative to the intermediate electrodes.

5. Method according to one of the preceding claims, characterised in that, during the metallization or etching, the printed circuit boards or conductor foils are disposed in a horizontal position and are guided in a horizontal direction.

6. Apparatus for the continuous, uniform, electrolytic metallization or etching of metal surfaces on printed circuit boards or conductor foils, comprising
- the metal surfaces,
- electrodes which are situated opposite said surfaces,
- a treatment agent which is in contact with the metal surfaces and the electrodes,
- a voltage source which is in electrical contact with the metal surfaces and the electrodes, and
- electrically non-contacted, insoluble, rotatable intermediate electrodes, which are disposed between the metal surfaces and the electrodes and are formed from an electrically conductive material, at least at portions of the external surface, said intermediate electrodes being provided externally with an electrically insulating intermediate layer and being configured as a roller.

7. Apparatus according to claim 6, characterised in that the intermediate electrode is provided on its external surface with electrically insulating spacer means.

8. Apparatus according to one of claims 6 or 7, characterised in that the electrodes are configured as plates.

9. Metallizing apparatus according to one of claims 6 to 8, characterised by electrodes formed from material to be deposited.

10. Use of an apparatus according to one of claims 6 to 9 for metallizing or etching printed circuit boards or conductor foils which are disposed in a horizontal position and are guided horizontally.

## Revendications

1. Procédé de métallisation ou d'attaque électrolytique homogène et continue de surfaces métalliques de circuits imprimés ou de feuilles conductrices dans lequel
- les surfaces et les électrodes opposées à celles-ci sont mises en contact avec un moyen de traitement,
- une tension électrique est appliquée entre les surfaces métalliques et les électrodes et
- dans lequel entre les surfaces métalliques et les électrodes sont disposées des électrodes intermédiaires non connectées électriquement, insolubes, réalisées dans un matériau électroconducteur au moins sur des parties de la surface extérieure et qui roulent à une distance réduite par rapport aux surfaces métalliques ou
- dans lequel les électrodes intermédiaires essuient les surfaces métalliques, une couche intermédiaire isolante électriquement étant introduite entre les électrodes intermédiaires et les surfaces métalliques et la vitesse de déplacement des électrodes intermédiaires étant réglée de manière appropriée par rapport à la surface métallique.

2. Procédé selon la revendication 1, caractérisé par un cylindre en rotation autour de son axe longitudinal et servant d'électrode intermédiaire.

3. Procédé de métallisation selon l'une quelconque des revendications précédentes, caractérisé en ce que des ions métalliques nécessaires à la métallisation sont ajoutés au moyen de traitement par la dissolution électrolytique des électrodes ou par des sels métalliques.

4. Procédé selon l'une quelconque des revendications précédentes, caractérisé en ce que les électrodes sont déplacées de manière continue ou intermittente par rapport aux électrodes intermédiaires.

5. Procédé selon l'une quelconque des revendications précédentes caractérisé en ce que les circuits imprimés ou feuilles conductrices sont disposés en position horizontale lors de la métallisation ou de l'attaque et sont guidés dans le sens horizontal.

6. Dispositif de métallisation ou d'attaque électrolytique homogène et continue de surfaces métalliques de circuits imprimés ou de feuilles conductrices, comprenant
- les surfaces métalliques,
- des électrodes opposées à celles-ci,
- un moyen de traitement en contact avec les surfaces métalliques et les électrodes,
- une source de tension en contact électrique avec les surfaces métalliques et les électrodes ainsi que
- des électrodes intermédiaires rotatives disposées entre les surfaces métalliques et les électrodes, non connectées électriquement, insolubes, réalisées dans un matériau électroconducteur au moins sur des parties de la surface extérieure, dotées à l'extérieur d'une couche intermédiaire isolante électriquement et conçues en tant que cylindre.

7. Dispositif selon la revendication 6, caractérisé en ce que l'électrode intermédiaire est dotée sur sa surface extérieure de moyens d'écartement isolants électriquement.

8. Dispositif selon la revendication 6 ou 7, caractérisé en ce que les électrodes sont conçues comme des plaques.

9. Dispositif de métallisation selon l'une quelconque des revendications 6 à 8, caractérisé par des électrodes réalisées dans un matériau devant se déposer.

10. Utilisation d'un dispositif selon l'une quelconque des revendications 6 à 9 pour la métallisation ou l'attaque de circuits imprimés ou de feuilles conductrices disposés en position horizontale et guidés dans le sens horizontal.
